# EUROPEAN PATENT APPLICATION

(11) **EP 4 279 160 A1**
(43) Date of publication of application: **22.11.2023**
(21) Application number: 22382483.0
(22) Date of filing: 19.05.2022
(51) Int. Cl.: B01D 1/00, B01D 3/02, B01D 3/10, B01D 5/00, G06F 1/20, H01L 23/427, H05K 7/20

(54) **DEVICE SUITABLE FOR DISTILLING A SOLVENT**

(71) Applicant: Van Rooyen, Willem, 43850 Cambrils Tarragona (ES)
(72) Inventor: VAN ROOYEN, Willem, E-43850 Cambrils - Tarragona (ES); COCOS, Florin, 900692 Constanta (RO); ABRAHAMS, Gavin, London, NW4 1EA (GB)
(74) Representative: ABG Intellectual Property Law, S.L.

(57) **Abstract**

The present invention is related to an apparatus and a process for distilling a solvent using the heat released by a semiconductor configured to be working at a predetermined operational temperature and pressure.

## Description

### FIELD OF THE INVENTION

The present invention is related to an apparatus and a method for distilling a solvent using the heat released by a semiconductor configured to be working at a predetermined operational temperature and pressure.

### PRIOR ART

Distillation is usually known and implemented for purifying a liquid by separating a first material from another which is either a non-volatile or a less-volatile material than the first material. This process, as well as being one of the most common laboratory techniques used by chemists today, is also a known process for separating the component substances of a mixture by adapting its evaporation and condensation parameters.

In a simpler way, distillation is a process of collecting the resultant hot vapor from the condensation of a liquid which has been previously heated until reaching its boiling point. Formerly, it was a common implemented process by chemists in order to isolate and, for example, create perfumes.

Some of the different methods known in the distillation field are, for example, the distillation at atmospheric pressure which is normally used at low temperature boiling and relatively pure organic liquid. Then, another known method is fractional distillation which occurs at atmospheric pressure and is used when separating mixtures of liquids at boiling points that differ by at least 70ºC. Finally, another of the most common method is the reduced pressure distillation under vacuum when the boiling point of one of the compound or solvent, to be separated, is considered too high to distill without significant decomposition of said compound upon heating at atmospheric pressure.

On the other hand, semiconductors are known as materials having an electrical conductivity value which falls between one of a conductor and an insulator. When the temperature of a semiconductor rises, its resistivity falls. Semiconductor devices can provide a lot of different properties such as passing current in an easier way in one direction than the other. Semiconductor devices also present variable resistance and have sensitivity to light and/or heat. Also, devices made of semiconductors are known for being used for amplification, switching and energy conversion since the conductivity of those devices can be improved by increasing its temperature.

The most common semiconductor devices are mostly made of silicon since it is a low cost raw material, having a simple processing and an interesting temperature range. Those semiconductor devices, in a non-limited list of material, can also be made of germanium, gallium arsenide, silicon carbide.

Some of the semiconductor devices with the highest power requirements are switches such as transistors, thyristors or more complex devices such as processors where heat dissipation is one of the biggest problems. High temperature variance causes long term degradation of the semiconductor and favors the appearance of internal diffusion mechanisms of the doped material leading to premature failure or total degradation of the device. However, a major cause of damage of semiconductors is due to the thermal contraction and expansion of said semiconductor material itself.

For this type of device, heat dissipation elements such as fins or coolers are known that seek to extract heat either passively or in a controlled manner, for example by using a temperature sensor that limits the temperature of the semiconductor.

However, purification systems are known for being high energy consuming, heat producing, low profitability and low sustainability. Therefore, there is a need in the art for a device which allows purification by distillation in a less power intensive way and with a lower cost of manufacturing for separating solvents and solutes providing solutions to the drawbacks previously mentioned.

### DESCRIPTION OF THE INVENTION

The present invention provides a solution for the above mentioned issues by an apparatus for distilling a solvent using the heat released by a semiconductor according to independent claim 1 and a process thereof according to independent claim 9. In dependent claims, preferred embodiments of the invention are defined.

*In a first inventive aspect, the present invention provides an apparatus for distilling a solvent using the heat released by a semiconductor configured to be working at a predetermined operational temperature, the apparatus comprising:*
- *a solvent feeding device;*
- *a boiling chamber fed by the solvent feeding device, the solvent feeding device adapted to keep a constant solvent level in the boiling chamber, the boiling chamber further comprising:*
   o *a heat exchange surface configured to put the solvent of the boiling chamber in thermal contact with the semiconductor;*
   o *a vapor steam outlet port;*
   o *a pressure sensor for measuring the pressure in the boiling chamber;*
- *a vacuum pump;*
- *a vapor condenser comprising a vapor inlet port and a liquid outlet port, the vapor inlet port in fluid communication with the vapor steam outlet port of the boiling chamber and, the liquid outlet port in fluid communication with the vacuum pump for reducing the pressure at the liquid outlet port;*
- *a distilled liquid outlet in fluid communication with the vacuum pump for outputting the distilled liquid;*
- *a processor at least in communication with the pressure sensor and the vacuum pump wherein the processor is adapted to:*
   *receive a setup pressure value, the setup pressure value being the pressure of the solvent when the solvent is boiling at the operational temperature of the semiconductor;*
   *continuously reading the measurement of the pressure sensor and actuating on the vacuum pump for setting the pressure of the boiling chamber at the setup pressure value.*

Throughout the whole document, "in fluid communication" will mean that it exists a fluid passage for a liquid or a gas from one element towards another element where both of these elements are physically or mechanically connected with each other. Therefore, the expression "in fluid communication" relates to the fact that a fluid, liquid or gas, is able to flow around from one element to the next.

The present invention is an apparatus for distilling a solvent using the heat produced by a semiconductor which is configured to be working at a predetermined operational temperature. The semiconductor is in thermal contact with a lower part of a boiling chamber fed with solvent. In operational mode, said lower part of the boiling chamber is a heat exchange surface which is configured for allowing thermal contact with the semiconductor such that the solvent reaches its boiling point temperature.

In some embodiments, the lower part of the boiling chamber, the heat exchange surface, corresponds to the solvent level inside the boiling chamber. In some other embodiments, when the invention is implemented for separating a liquid from a solid, the heat exchange surface is a side part of the boiling chamber and matches the internal solvent level.

In some embodiments, the solvent is water-based. In some other embodiments, the solvent can be volatile or toxic compounds.

In particular, the boiling point of the chosen solvent to be purified depends on its concentration. The higher the concentration, the higher the boiling point which results in adapting the pressure value inside the apparatus to the substance, solvent and nonsolvent components, to be distilled.

In some embodiments, the semiconductor is a metal-oxide semiconductor field-effect transistor, also called MOSFET. In some other embodiments, the semiconductor is made of a plurality of MOSFET semiconductors.

In some other embodiments, the semiconductor is a combination of field-effect transistors, also called finFETs and/or computational processor.

In operational mode, the boiling chamber is fed under demand with solvent through a solvent feeding device which, according to a preferred embodiment, allows the solvent level in the boiling chamberto be maintained at the same constant level along the whole process of distillation. By constantly maintaining the same level of solvent in the boiling chamber, this provides to the apparatus the capacity of always reproducing the distillation in the same condition and performing the purification in long term processes.

Also, the boiling chamber of the present invention comprises a vapor steam outlet port which is a top part of the boiling chamber that allows the vapor of the solvent to be oriented towards the vapor condenser. The vapor condenser, which allows the vapor-to-liquid conversion, comprises a vapor inlet port in fluid communication with the vapor steam outlet port and a liquid outlet port in fluid communication with a vacuum pump. The liquid outlet port allows the decrease of the pressure of the product before entering the vacuum pump.

In some embodiments, the vapor condenser is any condensation equipment known in the art which would be suitable for purifying the chosen solvent.

Then, the present invention comprises a distilled liquid outlet in fluid communication with the vacuum pump which is adapted, in operational mode, to output the distilled liquid and retrieve the final liquid product from the distillation. The vacuum pump actuates on the vapor condenser by fluid communication.

In some embodiment, an additional pressurized chamber is located between the liquid outlet of the vapor condenser and the vacuum pump in order to avoid that the liquid substrate damage said vacuum pump.

According to an embodiment, a pressure sensor is located inside the boiling chamber in order to consistently measure the pressure value inside the boiling chamber while in operational mode. The pressure at this point of the boiling chamber being the parameter allowing distillation of the solvent since the specified pressure defines the boiling temperature and, as a result, the temperature of the semiconductor device in operational mode. That is, the pressure in the boiling chamber will be adapted in order to ensure a temperature limit in the semiconductor.

In some other embodiments, the pressure sensor is located at any point of the device and consistently measures the pressure value through the whole apparatus in operational mode, which is almost the same at any point of said apparatus due to the fluid communication in between all elements; that is, the pressure drop may be taken as being negligible along the conduits and therefore the pressure at the boiling chamber is estimated by the measurement taken by the pressure sensor.

Another key parameter of the present invention apparatus is controlling the flow of solvent introduced into the boiling chamber from the solvent feeding device. The flow is controlled by the heat being released by the semiconductor device while in operational mode.

If the temperature limit of the semiconductor device is set up at a pre-specified value, a larger amount of heat being released may increment the temperature; however, a larger amount of heat will also evaporate a higher amount of liquid. A compensating measure operates controlling the pressure in the boiling chamber since if the pressure is decreased then the amount of thermal energy to be evacuated by evaporating a liquid will be increased preventing the temperature of the semiconductor device to overcome the temperature limit.

According to a preferred embodiment, the flow of the solvent introduced into the boiling chamber is such that the liquid level in the boiling chamber is constant. Therefore, the flow rate is adjusted according to the heat released by the semiconductor device. Also, other parameters such that the vacuum pump pressure, the gas cooling temperature and the coolant temperature are adjusted according to the heat released by the semiconductor.

In some embodiments, the solvent feeding device comprises a depth measurement to get real time data of distillation flux, such as volume distilled and time of distillation.

According to a preferred embodiment, the solvent to be distilled is stored in a vessel with a fluidic communication with the boiling chamber, a conduit that ends at the free surface level of the liquid predefined in the boiling chamber. In this way, the solvent in this vessel only comes out when the solvent level in the boiling chamber drops.

The present invention also comprises a vacuum pump which is responsible for providing suction of the gas/vapor from the boiling chamber in operational mode. In particular, the vacuum pump is preferably located at the end of the vapor condenser in order to have an effect on the entire vapor condenser column and the boiling chamber.

Finally, a processor is in communication with at least the pressure sensor and the vacuum pump where the processor is adapted to receive a setup pressure value being the pressure value of the solvent boiling at the operational temperature of the semiconductor.

In particular, an apparatus of the present invention provides control over the pressure inside the boiling chamber and the whole condenser column in order to maintain the solvent at its boiling point while in the boiling chamber and provide continuous distillation with a flow rate of the distilled liquid depending on the heat released rate from the semiconductor. The vaporization rate of the solvent from the boiling chamber depends on the power applied to the semiconductor and, thus, to the heat transferred from said semiconductor to the solvent. More power to the semiconductor, and greater vacuum suction pressure, results in a higher solvent distillation flow rate.

Also, the processor is adapted to continuously read the measurement of the pressure sensor and actuates on the vacuum pump in order to set the pressure of the boiling chamber at the setup pressure value while the apparatus is in operational mode. Advantageously, the processor allows the vacuum pump to be activated at some point where the pressure value in the boiling chamber is higher than the setup pressure value. Also, it contributes to the distillation of the solvent from the boiling chamber and maintains the temperature conditions of the semiconductor device ensuring that the temperature of the semiconductor device is under the temperature limit. In other words, the present invention provides a permanent fluid and gas flow-control(s) through the whole distillation process.

*In a particular embodiment, the vapor condenser comprises a coolant input port and a coolant output port for entering and outputting a coolant fluid evacuating heat of the solvent in the vapor-to-liquid conversion.*

By introducing a coolant fluid inside the vapor condenser, the solvent vapor steam from the boiling chamber is turned into liquid along the path of the vapor condenser. The vapor condenser comprises an input port and an output port for introducing and outputting a coolant fluid at a temperature which allows the vapor solvent to be cooled down and further evacuate the heat extracted from the vapor-to-liquid conversion.

In some embodiments, the coolant fluid comprises one of the following: water, aliphatics, polyalphaolefins, silicon oils, fluorocarbons, ethylene Glycol, propylene glycol, methanol, ethanol, calcium chloride solution, potassium formate/acetate solution, liquid metals.

Advantageously, by reducing the coolant fluid temperature, the flow rate is increased.

Additionally, the temperature of the coolant in the vapor condenser determines the lowest boiling point at which the solvent can be distilled under vacuum.

*In a particular embodiment, the apparatus further comprises a heat exchanger for heating the solvent fed into the boiling chamber, the heat exchanger receiving the heat from the coolant fluid from the vapor condenser.*

In operational mode, the heat exchanger is configured for receiving the heat from the coolant fluid output of the vapor condenser and transfer said heat to the solvent from the solvent feeding device in order to inject pre-heated solvent to the already present solvent inside the boiling chamber. By recycling the heat from the output coolant fluid, it minimizes the difference of temperature between solvent inside the boiling chamber which already reached its boiling temperature and the solvent newly injected from the solvent feeding device, thus, provides a higher production steam rate of the solvent while ensuring safe operative conditions of the semiconductor. Therefore, the preheating stage provides a more efficient flow of distillation.

*In a particular embodiment, the semiconductor is a processor.*

In some embodiments, the semiconductor is a processor being cooled by an apparatus as disclosed.

In a further embodiment, the semiconductor device is a processor having a strict limit of operational temperature.

In a further embodiment, the processor comprises a temperature sensor for carrying out temperature measurements on the processor

*In a particular embodiment, the setup pressure value is a correlation between the pressure value and the maximum operational temperature of the semiconductor.*

The reduced pressure in the boiling chamber means that boiling occurs at a lower temperature. This causes the heat flux extracted from the semiconductor to be higher and reduces its temperature. The correlation between pressure and temperature allows the processor to set the pressure in the boiling chamber so that in stationary mode the semiconductor device reaches the temperature according to the correlation between pressure and temperature.

*In a particular embodiment, the absolute difference between the solvent boiling point and the temperature of the heat exchange surface is in the range [0; 10ºC], preferably [0, 6ºC], more preferably [0; 3ºC], even more preferably close to theorical OºC.*

The apparatus of the invention enhances the rate of isothermal expansion of the solvent vapor through vacuum suction in order to attain and maintain a stable and pre-selected semiconductor temperature which is directly derived from the solvent's boiling point and the temperature of the semiconductor solvent thermal junction.

By lowering the absolute difference between the solvent boiling point and the temperature of the heat exchange surface towards theorical 0ºC, this provides to the apparatus a maximum transfer of heat from the semiconductor to the solvent and provide an improved efficiency of the thermal conductivity between the semiconductor and solvent.

*In a particular embodiment, the processor is further adapted to act on the vacuum pump increasing the pumping power if the pressure sensor reads a pressure over the setup pressure value.*

By increasing the pumping power of the vacuum pump, and since the vacuum pump is preferably located after the vapor condenser, this results in decreasing the pressure value inside the boiling chamber and, thus, allows the apparatus of the invention to match the pressure value down to the setup pressure value.

The use of pressure-temperature correlation also allows the pressure measurement to be used to reliably establish the temperature in the semiconductor device without having to measure the temperature.

*In a particular embodiment, the processor is further adapted to act on the vacuum pump decreasing the pumping power if the pressure sensor reads a pressure under the setup pressure value.*

By decreasing the pumping power of the vacuum pump, i.e reducing the suction, and since the vacuum pump is preferably located after the vapor condenser, this results in increasing the pressure value inside the boiling chamber and, thus, allows the apparatus of the invention to match the pressure value up to the setup pressure value.

In a second inventive aspect, the present invention provides a process for distilling a solvent using the heat released by a semiconductor in thermal contact with a boiling chamber and configured to be working at a predetermined operational temperature, the process comprising the steps of:
a) feeding the boiling chamber with a solvent till reaching a constant solvent level (I),
b) heating the solvent of the boiling chamber, using the heat released by the semiconductor, till reaching the predetermined operational temperature,
c) inserting a setup pressure value in a processor,
d) continuously measuring the pressure inside the boiling chamber,
e) continuously actuating on a vacuum pump responsive to the pressure measurements for setting the pressure of the boiling chamber at the setup pressure value.

In preferred embodiment of the invention, the particular embodiments mentioned in the first inventive aspect of the invention also applied for the process thereof.

In a particular embodiment of the second inventive aspect, during step e), the processor actuates on the vacuum pump by increasing the pumping power if the pressure measured in step d) is higher than the setup pressure value.

In another particular embodiment of the second inventive aspect, during step e), the processor actuates on the vacuum pump by decreasing the pumping power if the pressure measured in step d) is lower than the setup pressure value.

### DESCRIPTION OF THE DRAWINGS

These and other features and advantages of the invention will be seen more clearly from the following detailed description of a preferred embodiment provided only by way of illustrative and non-limiting example in reference to the attached drawing.

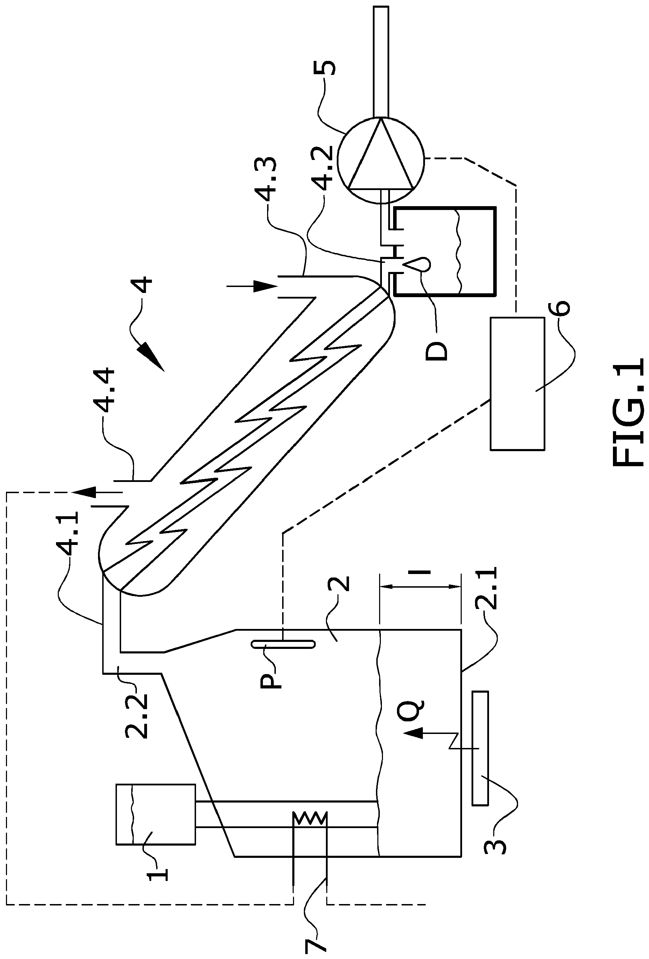

- Figure 1: This figure shows a distillation apparatus according to an embodiment of the invention.

### DETAILED DESCRIPTION OF THE INVENTION

As will be appreciated by one skilled in the art, aspects of the present invention may be embodied as an apparatus or device and process.

Figure 1 depicts a solvent feeding device (1) which is adapted to feed a boiling chamber (2) with solvent such that the boiling chamber (2) presents a constant solvent level (I) in order for the apparatus of the invention to continuously maintain the same conditions of distillation.

In some examples, the solvent is water-based. In some other embodiments, the solvent can be volatile or toxic compounds.

In some examples, the semiconductor (3) is a metal-oxide semiconductor field-effect transistor, also called MOSFET. In some other embodiments, the semiconductor is made of a plurality of MOSFET semiconductors. In some other embodiments, the semiconductor is a processor or a plurality of processors.

In some other examples, the semiconductor (3) is a processor.

The boiling chamber (2) presents a heat exchange surface (2.1) which is configured to put the solvent of the boiling chamber (2) in thermal contact with a semiconductor (3). Thanks to the heat emanating from the semiconductor (3), the temperature of the solvent contained inside the boiling chamber (2) increases until reaching the boiling point. Preferably, and as represented in Figure 1, the heat exchange surface (2.1) is the lower part of the boiling chamber (2).

In some other examples, when the invention is implemented for separating a liquid from a solid, the heat exchange surface is a side part of the boiling chamber (2) and matches the internal solvent level.

Preferably, the absolute difference between the solvent boiling point and the temperature of the heat exchange surface (2.1) is in the range [0; 10ºC], preferably [0, 6ºC], more preferably [0; 3ºC], even more preferably close to theorical OºC. Setting up an absolute difference between the solvent boiling point and the temperature of the heat exchange surface (2.1) allows to model the thermal insulation caused by the physical means separating the solvent and the semiconductor (3) generating heat.

At the top, the boiling chamber (2) presents a vapor steam outlet port (2.2) which is in fluid communication with a vapor inlet port (4.1) of a vapor condenser (4). Both the vapor steam outlet port (2.2) and the vapor inlet port (4.1) recollect the vapor coming from the boiling solvent from the boiling chamber (2).

Then, the vapor condenser (4) depicted in Figure 1 also comprises a liquid outlet port (4.2) located at the opposite side of the vapor condenser (4) with respect to the vapor inlet port (4.1). In between the vapor inlet port (4.1) and the liquid outlet port (4.2), the solvent, in a vapor state when at the vapor inlet port (4.1), is progressively converted to liquid thanks to a coolant fluid in thermal contact with the vapor condenser (4) column which is introduced through an input port (4.3) and extracted through an output port (4.4). Said coolant fluid is introduced in the vapor condenser (4) in order to evacuate heat of the solvent which is produced during the vapor-to-liquid conversion.

In some examples, the coolant fluid comprises one of the following: water, aliphatics, polyalphaolefins, silicon oils, fluorocarbons, ethylene Glycol, propylene glycol, methanol, ethanol, calcium chloride solution, potassium formate/acetate solution, liquid metals.

In the embodiment of Figure 1, the heat from the coolant fluid which is output from the output port (4.4) of the vapor condenser (4) is recycled and carried towards a heat exchanger (7), located inside or outside the boiling chamber (2), in order to heat the solvent coming from the solvent feeding device (1) into the boiling chamber (2). Thanks to the heat exchanger (7), the temperature of the solvent from the feeding device (1) increases and provides a lower difference of temperature between the one from the solvent of the feeding device (1) and the one from the solvent already present inside the boiling chamber (2) when the temperature of the solvent inside the boiling chamber (2) is the boiling temperature of said solvent. The preheated solvent now requires a lower amount of thermal energy to reach boiling and therefore, with the same heat provided by the semiconductor (3) the apparatus has a higher production of evaporated and, finally, distilled solvent.

Then, the liquid outlet port (4.2) of the vapor condenser (4) is in fluid communication with a vacuum pump (5) in order to reduce the pressure at the liquid outlet port (4.2) and inside the boiling chamber (2). On the opposite side of the fluid communication between the liquid outlet port (4.2) and the vacuum pump (5), said vacuum pump (5) is in fluid communication with a distilled liquid outlet (D) for outputting the product. In some examples, as depicted in Figure 1, the product outlet (D) is constantly dripping inside a pressurized chamber which collects the final product. Additionally, in the same example of Figure 1, the vacuum pump (5) is placed downstream of the pressurized chamber in order to avoid liquid entering and damaging the vacuum pump (5). The vacuum pump (5) is actuating on the pressure inside the pressurized chamber and, by extension thanks to fluid communication in between elements of the present invention, actuates on the pressure value of the whole apparatus.

The vacuum pump (5) operates on the gas phase since the energy introduced into the vacuum pump (5) is lower than using other means for reducing the pressure in the boiling chamber.

Figure 1 also depicts a processor (6) which is connected on one side to the vacuum pump (5) and on the other side to a pressure sensor (P) and where both connection to those elements are represented with discontinued lines. The pressure sensor (P) is located in the boiling chamber (2) and configured for measuring the pressure inside said boiling chamber (2). The processor (6) is at least in communication with the pressure sensor (P) and the vacuum pump (5). Furthermore, the processor (6) is adapted to receive a setup pressure value where the setup pressure value being the pressure of the solvent when the solvent is boiling at the operational temperature of the semiconductor (3). The processor (6) is also adapted to continuously read the measurement of the pressure sensor (P) and actuating on the vacuum pump (5) for setting the pressure of the boiling chamber (2) at the setup pressure value.

In some examples, the processor (6) is further adapted to act on the vacuum pump (5) increasing the pumping (5) power if the pressure sensor (P) reads a pressure over the setup pressure value. In some examples, other or combined, the processor (6) is further adapted to act on the vacuum pump (5) decreasing the pumping (5) power if the pressure sensor (P) reads a pressure under the setup pressure value. In other words, the processor (6) controls the boiling point of the solvent in the boiling chamber (2) by increasing or decreasing the pressure value and, thus, achieving the temperature value that is needed.

In a particular embodiment, temperature date is sent from the semiconductor (3) to the processor(6).

## Claims

1. Apparatus for distilling a solvent using the heat released by a semiconductor (3) configured to be working at a predetermined operational temperature, the apparatus comprising:
- a solvent feeding device (1);
- a boiling chamber (2) fed by the solvent feeding device (1), the solvent feeding device (1) adapted to keep a constant solvent level (I) in the boiling chamber (2), the boiling chamber (2) further comprising:
o a heat exchange surface (2.1) configured to put the solvent of the boiling chamber (2) in thermal contact with the semiconductor (3);
o a vapor steam outlet port (2.2);
o a pressure sensor (P) for measuring the pressure in the boiling chamber (2);
- a vacuum pump (5);
- a vapor condenser (4) comprising a vapor inlet port (4.1) and a liquid outlet port (4.2), the vapor inlet port (4.1) in fluid communication with the vapor steam outlet port (2.2) of the boiling chamber (2) and, the liquid outlet port (4.2) in fluid communication with the vacuum pump (5) for reducing the pressure at the liquid outlet port (4.2);
- a distilled liquid outlet (D) in fluid communication with the vacuum pump (5) for outputting the distilled liquid;
- a processor (6) at least in communication with the pressure sensor (P) and the vacuum pump (5) wherein the processor (6) is adapted to:
receive a setup pressure value, the setup pressure value being the pressure of the solvent when the solvent is boiling at the operational temperature of the semiconductor (3);
continuously reading the measurement of the pressure sensor (P) and actuating on the vacuum pump (5) for setting the pressure of the boiling chamber (2) at the setup pressure value.

2. An apparatus according to claim 1, wherein the vapor condenser (4) comprises a coolant input port (4.3) and a coolant output port (4.4) for entering and outputting a coolant fluid evacuating heat of the solvent in the vapor-to-liquid conversion.

3. An apparatus according to claim 2, wherein the apparatus further comprises a heat exchanger (7) for heating the solvent fed into the boiling chamber (2), the heat exchanger (7) receiving the heat from the coolant fluid from the vapor condenser (4).

4. An apparatus according to any of previous claims, wherein the semiconductor (3) is a processor.

5. An apparatus according to any of previous claims, wherein the setup pressure value is a correlation between the pressure value and the maximum operational temperature of the semiconductor (3).

6. An apparatus according to any of previous claims, wherein the absolute difference between the solvent boiling point and the temperature of the heat exchange surface (2.1) is in the range [0; 10ºC], preferably [0, 6ºC], more preferably [0; 3ºC], even more preferably close to theorical OºC.

7. An apparatus according to any of previous claims, wherein the processor (6) is further adapted to act on the vacuum pump (5) increasing the pumping power if the pressure sensor (P) reads a pressure over the setup pressure value.

8. An apparatus according to any of the previous claims, wherein the processor (6) is further adapted to act on the vacuum pump (5) decreasing the pumping power if the pressure sensor (P) reads a pressure under the setup pressure value.

9. A process for distilling a solvent using the heat released by a semiconductor (3) in thermal contact with a boiling chamber (2) and configured to be working at a predetermined operational temperature, the process comprising the steps of:
a) feeding the boiling chamber (2) with a solvent till reaching a constant solvent level (I),
b) heating the solvent of the boiling chamber (2), using the heat released by the semiconductor (3), till reaching the predetermined operational temperature,
c) inserting a setup pressure value in a processor (6),
d) continuously measuring the pressure inside the boiling chamber (2),
e) continuously actuating on a vacuum pump (5) responsive to the pressure measurements for setting the pressure of the boiling chamber (2) at the setup pressure value.

10. The process according to claim 9, wherein, during step e), the processor (6) actuates on the vacuum pump (5) by increasing the pumping power if the pressure measured in step d) is higher than the setup pressure value.

11. The process according to claim 9, wherein, during step e), the processor (6) actuates on the vacuum pump (5) by decreasing the pumping power if the pressure measured in step d) is lower than the setup pressure value.
